# EUROPEAN PATENT SPECIFICATION

(11) **EP 3 422 462 B1**
(45) Date of publication and mention of the grant of the patent: **14.04.2021**
(21) Application number: 17305803.3
(22) Date of filing: 27.06.2017
(51) Int. Cl.: H01M 10/42, H01M 10/06, H01M 10/48, G01R 19/165, G01R 31/371, G01R 31/379, G01R 31/3835

(54) **BATTERY MONITORING DEVICE**
BATTERIEÜBERWACHUNGSVORRICHTUNG
DISPOSITIF DE PILOTAGE DE BATTERIE

(43) Date of publication of application: 02.01.2019
(73) Proprietor: Eh Europe GmbH, 6300 Zurich (CH)
(72) Inventor: DUHAUT, Francis, 62033 Arras (FR); LETOMBE, David, 62033 Arras (FR); BEAUCAMP, François, 62033 Arras (FR)
(74) Representative: Abel & Imray

(56) References cited:
- EP-A1- 2 645 524
- WO-A2-2006/094287
- KR-B1- 101 663 579
- US-A- 5 095 537
- US-A- 5 488 300
- US-A1- 2011 106 280
- US-A1- 2011 260 735

## Description

### Field of the Invention

The present invention concerns a battery monitoring device.

### Background of the Invention

In order to maintain batteries, for example lead-acid batteries, in good order, it is necessary to ensure that they are kept in suitable conditions. For example, it may be necessary to monitor the electrolyte level in a lead-acid battery to ensure the electrolyte level does not drop below a minimum level. Other characteristics which may be monitored include battery temperature and voltage. Various sensor devices may be associated with a battery in order to achieve this level of monitoring. However, applying the various sensor devices, and arranging them to provide the necessary information, can take time and engineering expertise. Therefore, complexity and cost may be added to the battery manufacturing process.

The US 2011/106280 A1 discloses a battery monitoring device comprising: an electrolyte level sensor comprising a probe, a temperature sensor, a voltage sensor, and a wireless communications unit, a head unit, the probe extending from the head unit.

The present invention seeks to mitigate the above-mentioned problems. Alternatively or additionally, the present invention seeks to provide an improved battery monitoring device, and/or battery.

### Summary of the Invention

The present invention provides, according to a first aspect, a battery monitoring device comprising:
an electrolyte level sensor comprising a probe,
a temperature sensor,
a voltage sensor, and
a wireless communications unit, a head unit, the probe extending from the head unit, wherein the head unit comprises the temperature sensor, voltage sensor, and wireless communications unit.

Advantageously, the battery monitoring device provides a single unit which may be installed on a battery in order to monitor the battery electrolyte level, the temperature of the battery, and the voltage of the battery. The wireless communications unit may be configured to send wireless communications to remote receiving or monitoring devices.

The battery monitoring device may be configured to send a notification via the wireless communication unit in the event of detecting an electrolyte level below a certain threshold value. Therefore, the battery monitoring device, when installed on a battery, may protect the battery from damage due to electrolyte levels dropping below a minimum level.

The battery monitoring device may be configured to send a notification via the wireless communication unit in the event of detecting a temperature above or below certain threshold values. Therefore, the battery monitoring device, when installed on a battery, may protect the battery from getting too hot, or too cold.

The battery monitoring device may be configured to send a notification via the wireless communication unit in the event of detecting a voltage below a certain threshold value. Therefore, the battery monitoring device, when installed on a battery, may prevent the battery from over-discharge.

An example remote monitoring device may be a smart phone or tablet, or other computer device. The wireless communication device may be a Bluetooth <RTM> communication device. Alternatively or additionally, the wireless communication device may be configured to be connected to a wireless network, such as Wi-Fi.

The battery monitoring device may comprise a memory unit. The memory unit may be configured to collect and store inputs from the electrolyte level sensor, the temperature sensor, and/or the voltage sensor. The memory unit may store the inputs from the electrolyte level sensor, the temperature sensor, and/or the voltage sensor, such that the data may be accessed by a remote device, such as a computer, a smart phone, or tablet.

The data stored by the memory unit may be sent to a remote computer and analysed in order to detect if the battery has been in a suboptimal condition for any period of time. For example, it may be helpful to know if the battery electrolyte levels have been allowed to drop too low in the event of a warranty claim on the battery. Alternatively or additionally, it may be helpful when investigating a warranty claim to know whether the battery has been stored in a cold environment, or over-discharged during use.

The data stored by the memory unit may be sent to a remote device, such as a computer, smart phone or tablet, and analysed to provide a picture of the lifecycle of the battery to which the battery monitoring device is installed. Such information may include the number of times the battery has been charged/discharged.

The battery monitoring device may comprise an alarm, for example an audible or visual alarm. The battery monitoring device may comprise one or more LEDs. The alarm may be activated in response to the battery electrolyte level dropping too low, the battery temperature increasing or decreasing beyond certain threshold values, and/or the battery voltage dropping below a certain threshold value.

The head unit may also comprise one or more LEDs. The head unit may comprise a push button, the push button configured to activate the wireless communications unit. The push button may be configured to activate the wireless communications unit such that data obtained by the battery monitoring device is transmitted to an outside source, such as a computer, smart phone or tablet.

According to a second aspect of the invention, there is also provided a battery, the battery comprising a plurality of lead-acid plates at least partially submerged in an electrolyte solution, and a battery monitoring device according to the first aspect of the invention.

The battery monitoring device is arranged to measure the battery electrolyte level, the temperature of the battery, and the voltage of the battery. The battery monitoring device may be arranged to monitor and record at least one of the battery electrolyte level, the temperature of the battery, and the voltage of the battery. The battery monitoring device may be arranged to send data concerning at least one of the battery electrolyte level, the temperature of the battery, and the voltage of the battery to a remote receiving device, such as a computer, a smart phone, or tablet. The battery monitoring device may be arranged to send data via Bluetooth <RTM> or other suitable wireless communication method.

It will of course be appreciated that features described in relation to one aspect of the present invention may be incorporated into other aspects of the present invention. For example, the method of the invention may incorporate any of the features described with reference to the apparatus of the invention and *vice versa.*

### Description of the Drawings

Embodiments of the present invention will now be described by way of example only with reference to the accompanying schematic drawings of which:
- Figure 1: shows an isometric view of a battery monitoring device according to a first embodiment of the invention;
- Figure 2: shows a schematic view of the battery monitoring device according to the first embodiment of the invention;
- Figure 3: shows a battery according to a second embodiment of the invention, including the battery monitoring device according to the first embodiment of the invention; and
- Figure 4: shows a battery monitoring device according to a third embodiment of the invention.

### Detailed Description

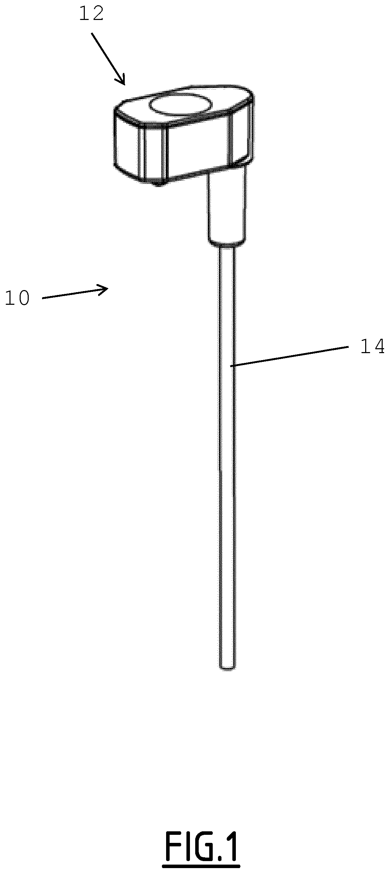

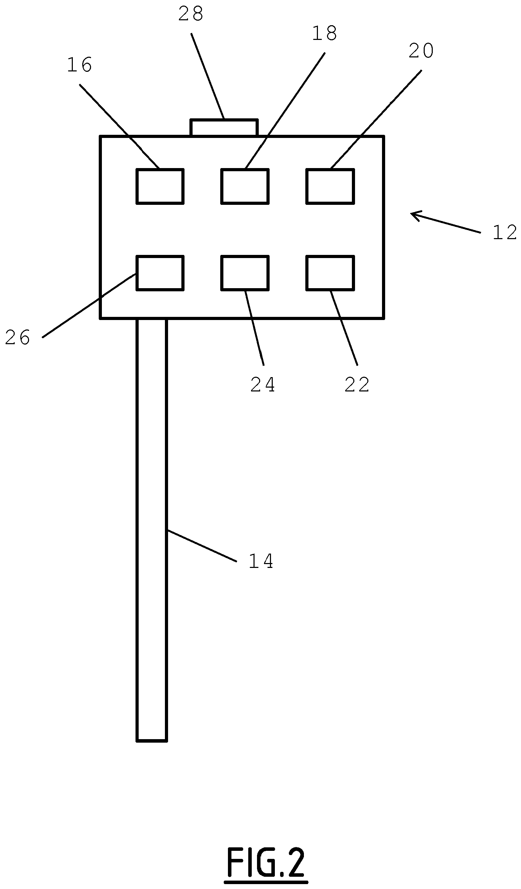

Figures 1 and 2 show a battery monitoring device 10 comprising a head unit 12 and a lead probe 14 extending from the head unit 12. The head unit comprises an electrolyte level sensor 16 connected to the lead probe 14, a temperature sensor 18, and a voltage sensor 20. The head unit 12 further comprises a wireless communication unit 22, configured to communicate via Bluetooth <RTM>, and a memory unit 24. The head unit 12 further comprises an LED 26 and a push button 28.

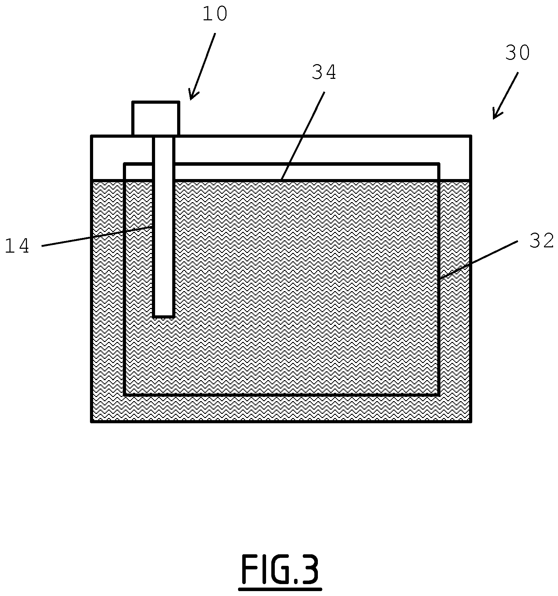

Figure 3 shows the battery monitoring device 10 inserted into a lead-acid battery 30. The lead-acid battery 30 comprises a plurality of lead plates 32 at least partially submerged in an electrolyte 34. The lead probe 14 is arranged to detect the level of the electrolyte in conjunction with the electrolyte sensor 16. The temperature sensor 18 is arranged to detect the temperature of the battery 30. The voltage sensor is arranged to detect the voltage of the battery 30. The electrolyte sensor 16, the temperature sensor 18, and voltage sensor 20, are each arranged to send information about the electrolyte level, the temperature, and voltage of the battery 30 to the memory 24. The memory 24 is arranged to store this information. The electrolyte sensor 16, the temperature sensor 18, and voltage sensor 20 are also each arranged to send information about the electrolyte level, the temperature, and voltage of the battery 30 to the wireless communications unit 22. The wireless communications unit 22 is arranged to send this information/data to remote devices, for example a computer, smart phone, or tablet. Therefore, a user may easily check the physical status of the battery 30 by reviewing the data provided by the wireless communications unit 22. In the event that electrolyte sensor 16, the temperature sensor 18, or voltage sensor 20, detects that the battery is in an undesirable status, for example with a low electrolyte level, too hot, too cold, or in danger of over discharge, the wireless communication unit may send a notification to a remote device, for example computer, smart phone, or tablet. The wireless communication unit may send a notification to a battery control device, for example a WI IQ device, as is available from Enersys EMEA, 6300 Zug - Switzerland. Alternatively, or in addition to the notification, the LED 26 may be activated, for example in a flashing pattern, to indicate that the battery 30 needs some attention.

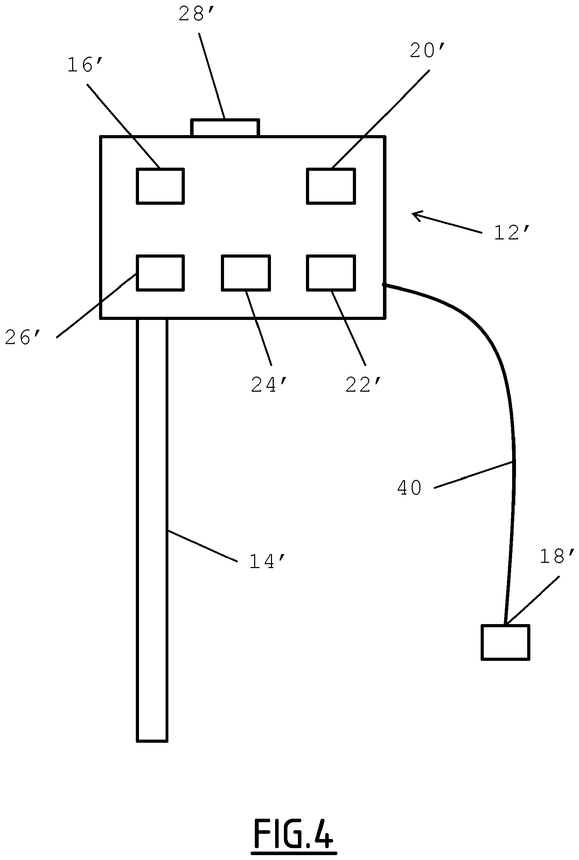

Figure 4 shows a battery monitoring device 10' similar to that shown in figures 1 and 2. Where like features exist, they are denoted by the reference number being annotated as X'. In contrast to the arrangement shown in figures 1 and 2, the temperature sensor 18' is located towards the end of a temperature probe 40, which extends from the head unit 12'. The temperature sensor 18' may be located at the most appropriate location in a battery, which may differ from where the head unit 12' of the battery monitoring device 10' is located. The temperature probe 40 comprises a wired arrangement extending from the temperature sensor 18' back to the head unit 12', where the output of the temperature sensor 18' may be processed in the same way as described with reference to the above embodiments.

Whilst the present invention has been described and illustrated with reference to particular embodiments, it will be appreciated by those of ordinary skill in the art that the invention lends itself to many different variations not specifically illustrated herein.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A battery monitoring device (10) comprising:
an electrolyte level sensor (16) comprising a probe (14),
a temperature sensor (18),
a voltage sensor (20), and
a wireless communications unit (22),
a head unit (12), the probe (14) extending from the head unit (12), **characterized in that** the head unit (12) comprises the temperature sensor (18), voltage sensor (20), and wireless communications unit (22).

2. A battery monitoring device (10) as claimed in claim 1, configured to send a notification via the wireless communication unit (22) in the event of detecting an electrolyte level below a certain threshold value.

3. A battery monitoring device (10) as claimed in claim 1 or claim 2, configured to send a notification via the wireless communication unit (22) in the event of detecting a temperature above or below certain threshold values.

4. A battery monitoring device (10) as claimed in any of claims 1 to 3, configured to send a notification via the wireless communication unit (22) in the event of detecting a voltage below a certain threshold value.

5. A battery monitoring device (10) as claimed in any preceding claim, wherein the wireless communication device (22) is a Bluetooth <RTM> communication device.

6. A battery monitoring device as claimed in any preceding claim, wherein the battery monitoring device (22) comprises a memory unit (24).

7. A battery monitoring device (10) as claimed in claim 6, wherein the memory unit (24) is configured to collect and store inputs from the electrolyte level sensor (16), the temperature sensor (18), and/or the voltage sensor (20) .

8. A battery monitoring device (10) as claimed in any preceding claim, further comprising an alarm.

9. A battery monitoring device as claimed in any preceding claim, wherein the electrolyte level sensor comprises a lead probe.

10. A battery monitoring device as claimed in claim 1, wherein the head unit (12) comprises one or more LEDs (26) .

11. A battery monitoring device (10) as claimed in claim 1, wherein the head unit (12) comprises a push button (28), the push button (28) configured to activate the wireless communications unit(22).

12. A battery (30), the battery comprising a plurality of lead-acid plates (32) at least partially submerged in an electrolyte solution (34), and a battery monitoring device (10) according to any of claims 1 to 11.

## Patentansprüche

1. Batterieüberwachungseinrichtung (10), umfassend:
einen Elektrolytfüllstandssensor (16), der einem Fühler (14) umfasst,
einen Temperatursensor (18),
einen Spannungssensor (20) und
eine drahtlose Kommunikationseinheit (22),
eine Kopfeinheit (12), wobei der Fühler (14) sich von der Kopfeinheit (12) aus erstreckt, **dadurch gekennzeichnet, dass** die Kopfeinheit (12) den Temperatursensor (18), den Spannungssensor (20) und die drahtlose Kommunikationseinheit (22) umfasst.

2. Batterieüberwachungseinrichtung (10) wie in Anspruch 1 beansprucht, die konfiguriert ist, um über die drahtlose Kommunikationseinheit (22) eine Benachrichtigung zu senden, wenn ein Elektrolytfüllstand unter einem bestimmten Schwellenwert ermittelt wird.

3. Batterieüberwachungseinrichtung (10) wie in Anspruch 1 oder Anspruch 2 beansprucht, die konfiguriert ist, um über die drahtlose Kommunikationseinheit (22) eine Benachrichtigung zu senden, wenn eine Temperatur über oder unter bestimmten Schwellenwerten ermittelt wird.

4. Batterieüberwachungseinrichtung (10) wie in einem der Ansprüche 1 bis 3 beansprucht, die konfiguriert ist, um über die drahtlose Kommunikationseinheit (22) eine Benachrichtigung zu senden, wenn eine Spannung unter einem bestimmten Schwellenwert ermittelt wird.

5. Batterieüberwachungseinrichtung (10) wie in einem vorhergehenden Anspruch beansprucht, wobei die drahtlose Kommunikationseinrichtung (22) eine Bluetooth®-Kommunikationseinrichtung ist.

6. Batterieüberwachungseinrichtung wie in einem vorhergehenden Anspruch beansprucht, wobei die Batterieüberwachungseinrichtung (22) eine Speichereinheit (24) umfasst.

7. Batterieüberwachungseinrichtung (10) wie in Anspruch 6 beansprucht, wobei die Speichereinheit (24) konfiguriert ist, um Eingaben vom Elektrolytfüllstandssensor (16), vom Temperatursensor (18) und/oder vom Spannungssensor (20) zu sammeln und zu speichern.

8. Batterieüberwachungseinrichtung (10) wie in einem vorhergehenden Anspruch beansprucht, die ferner einen Alarm umfasst.

9. Batterieüberwachungseinrichtung wie in einem vorhergehenden Anspruch beansprucht, wobei der Elektrolytfüllstandssensor einen Bleifühler umfasst.

10. Batterieüberwachungseinrichtung wie in Anspruch 1 beansprucht, wobei die Kopfeinheit (12) eine oder mehrere LEDs (26) umfasst.

11. Batterieüberwachungseinrichtung (10) wie in Anspruch 1 beansprucht, wobei die Kopfeinheit (12) eine Drucktaste (28) umfasst, wobei die Drucktaste (28) konfiguriert ist, um die drahtlose Kommunikationseinheit (22) zu aktivieren.

12. Batterie (30), wobei die Batterie eine Mehrzahl von Blei-Säure-Platten (32), die wenigstens zum Teil in eine Elektrolytlösung (34) getaucht sind, und eine Batterieüberwachungseinrichtung (10) gemäß einem der Ansprüche 1 bis 11 umfasst.

## Revendications

1. Dispositif de surveillance de batterie (10) comprenant :
- un capteur de niveau d'électrolyte (16) comprenant une sonde (14),
- un capteur de température (18),
- un capteur de tension (20), et
- une unité de communications sans fil (22),
- une unité de tête (12), la sonde (14) s'étendant à partir de l'unité de tête (12), **caractérisée en ce que**
l'unité de tête (12) comprend le capteur de température (18), le capteur de tension (20), et l'unité de communications sans fil (22).

2. Dispositif de surveillance de batterie (10) selon la revendication 1, configuré pour envoyer une notification par l'intermédiaire de l'unité de communication sans fil (22) dans le cas où l'on détecte que le niveau d'électrolyte se situe en dessous d'une certaine valeur de seuil.

3. Dispositif de surveillance de batterie (10) selon la revendication 1 ou 2, configuré pour envoyer une notification par l'intermédiaire de l'unité de communication sans fil (22) dans le cas où l'on détecte que la température se situe au-dessus ou en dessous de certaines valeurs de seuil.

4. Dispositif de surveillance de batterie (10) selon l'une quelconque des revendications 1 à 3, configuré pour envoyer une notification par l'intermédiaire de l'unité de communication sans fil (22) dans le cas où l'on détecte qu'une tension se situe en dessous d'une certaine valeur de seuil.

5. Dispositif de surveillance de batterie (10) selon l'une quelconque des revendications précédentes, dans lequel le dispositif de communication sans fil (22) est un dispositif de communication Bluetooth <RTM>.

6. Dispositif de surveillance de batterie (10) selon l'une quelconque des revendications précédentes, dans lequel le dispositif de surveillance de batterie (22) comprend une unité de mémoire (24).

7. Dispositif de surveillance de batterie (10) selon la revendication 6, dans lequel l'unité de mémoire (24) est configurée pour recueillir et stocker des entrées en provenance du capteur de niveau d'électrolyte (16), du capteur de température (18), et / ou du capteur de tension (20).

8. Dispositif de surveillance de batterie (10) selon l'une quelconque des revendications précédentes, comprenant en outre une alarme.

9. Dispositif de surveillance de batterie (10) selon l'une quelconque des revendications précédentes, dans lequel le capteur de niveau d'électrolyte comprend une sonde en plomb.

10. Dispositif de surveillance de batterie selon la revendication 1, dans lequel l'unité de tête (12) comprend une ou plusieurs LED (26).

11. Dispositif de surveillance de batterie (10) selon la revendication 1, dans lequel l'unité de tête (12) comprend un bouton poussoir (28), le bouton poussoir (28) étant configuré pour activer l'unité de communications sans fil (22).

12. Batterie (30), la batterie comprenant une pluralité de plaques de plomb - acide (32) immergées en partie au moins dans une solution d'électrolyte (34), et un dispositif de surveillance de batterie (10) selon l'une quelconque des revendications 1 à 11.
